# EUROPÄISCHE PATENTSCHRIFT

(11) **EP 2 092 814 B1**
(45) Veröffentlichungstag und Bekanntmachung des Hinweises auf die Patenterteilung: **18.12.2013**
(21) Anmeldenummer: 07817775.5
(22) Anmeldetag: 06.11.2007
(51) Int. Cl.: H05K 5/00, H05K 5/02, B66C 13/40

(54) **BEDIENGERÄT, INSBESONDERE FERNSTEUERGERÄT FÜR INDUSTRIEGERÄTE**
CONTROL DEVICE, PARTICULARLY REMOTE CONTROL FOR INDUSTRIAL APPLIANCES
APPAREIL DE COMMANDE, EN PARTICULIER APPAREIL DE TÉLÉCOMMANDE POUR APPAREILS INDUSTRIELS

(30) Priorität: 09.11.2006 DE 202006017127 U
(43) Veröffentlichungstag der Anmeldung: 26.08.2009
(73) Patentinhaber: Haug, Thomas, 75217 Birkenfeld (DE)
(72) Erfinder: Haug, Thomas, 75217 Birkenfeld (DE)
(74) Vertreter: Schön, Thilo
(86) Internationale Anmeldenummer: PCT/DE2007/001987
(87) Internationale Veröffentlichungsnummer: WO 2008/055480

(56) Entgegenhaltungen:
- EP-A- 1 683 753
- WO-A-03/064311
- WO-A-2005/033822
- DE-A1- 1 665 081
- DE-A1- 3 334 272
- FR-A- 2 595 852

## Beschreibung

### Technischer Hintergrund

Die Erfindung betrifft ein Bediengerät, insbesondere Fernsteuergerät für Industriegeräte, mit einem Gehäuse zur Aufnahme der Steuerelektronik und mindestens eines Bedienelementes.

Derartige Bediengeräte sind seit Jahren im Einsatz und werden beispielsweise zur Fernsteuerung von Kränen auf Baustellen eingesetzt. Beim Gehäuse handelt es sich meistens um kastenförmige Gebilde, die entweder unmittelbar von den Händen des Benutzers gehalten werden, oder aber über einen Tragegurt, mit dessen Hilfe das Bediengerät vor dem Körper der Bedienperson gehalten wird, die dann die Hände zur Bedienung beispielsweise von zwei Joysticks frei hat.

Derartige Bediengeräte gibt es in verschiedensten technischen Ausgestaltungen und Formgebungen, was dementsprechend individuelle Fertigungsmaßnahmen erfordert.

EP 1 683 753 A1 beschreibt eine Fernsteuerung für einen Kran. Diese weist mehrere Steuerungselemente auf, die nebeneinander an einem unteren Gehäuseteil gehalten sind. Von einem Ende zum anderen Ende dieses Gehäuseteils erstreckt sich dabei eine schalenförmige Handauflage U-förmig oberhalb der Steuerungselemente.

DE 33 34 272 A1 beschreibt allgemein ein Gehäuse für handgehaltene Geräte, das im Wesentlichen aus einem passend abgelängten, beispielsweise stranggepressten Rohrprofil besteht. Das Rohrprofil dient dabei insbesondere zur Aufnahme einer elektronischen Baugruppe und ist an seinen Enden durch Endkappen verschließbar, die beispielsweise aus Kunststoff gebildet sind.

DE 16 65 081 A1 beschreibt ein Gehäuse für ein elektrisches Bediengerät, das einen Deckel und einen Kastenunterteil aufweist, die aus geschnittenen Profilteilen zusammen gesetzt sind. Beide U-förmigen Profilteile werden über eine Dichtung aneinander angelegt und mittels endseitiger Anbringung zweier Stirnteile aus Gummi zueinander festgelegt.

### Darstellung der Erfindung

Es ist Aufgabe der Erfindung, ein gattungsgemäßes Bediengerät so zu konzipieren, dass es aus einfachen Grundbauteilen in variablen Dimensionen in einfachen Bearbeitungsschritten herstellbar ist.

Eine weitere Aufgabe der Erfindung besteht darin, dass das derart konzipierte Gehäuse mit weiteren Bauteilen einfach ergänzt werden können, die eine zusätzliche Funktionalität in Anpassung an den Einsatzzweck und/oder die verwendeten Bedienungselemente wie z.B. Joysticks haben. Das Bediengerät soll also aus Standardbauteilen möglichst individuell konfigurierbar sein. Dabei sollen die Bedienelementen geschützt sein.

Erfindungsgemäß wird diese Aufgabe mit den Merkmalen des Schutzanspruchs 1 gelöst.

Der Grundgedanke der Erfindung ist somit darin zu sehen, dass das Gehäuse aus einfachen Bauteilen, nämlich Wandungsteil und die Stirnseiten verschließenden Halteelementen als "Basismodule" zusammengesetzt ist, die gemäß vorteilhaften Ausgestaltungen, die in den Unteransprüchen angegeben sind, in vielfältiger Weise erweitert werden können, so dass ein individuell konfiguriertes Bediengerät entsteht, das modulartig oder baukastenartig aufgebaut ist.

Durch geeignete Materialwahl der Bauteile können hierbei verschiedene Anforderungsstufen an mechanische Stabilität, Haltbarkeit, Lebensdauer, Herstellungskosten usw. realisiert werden, die individuelle Konfiguration kann somit weitgehend "aus dem Lagerregal" erfolgen.

### Kurze Beschreibung der Zeichnungen

Ein bevorzugtes Ausführungsbeispiel des Bediengeräts wird nun anhand eines industriellen Fernsteuergeräts näher erläutert, es zeigen:
- Figur 1:: Eine perspektivische Gesamtdarstellung von oben,
- Figur 2:: eine perspektivische Gesamtdarstellung von unten,
- Figur 3:: eine Aufsicht,
- Figur 4:: eine Seitenansicht,

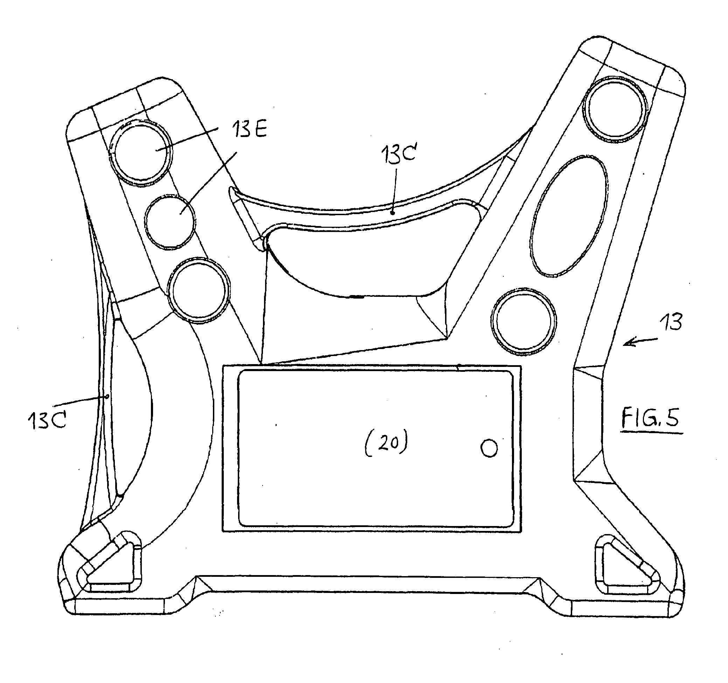

- Figur 5:: eine Frontalansicht,

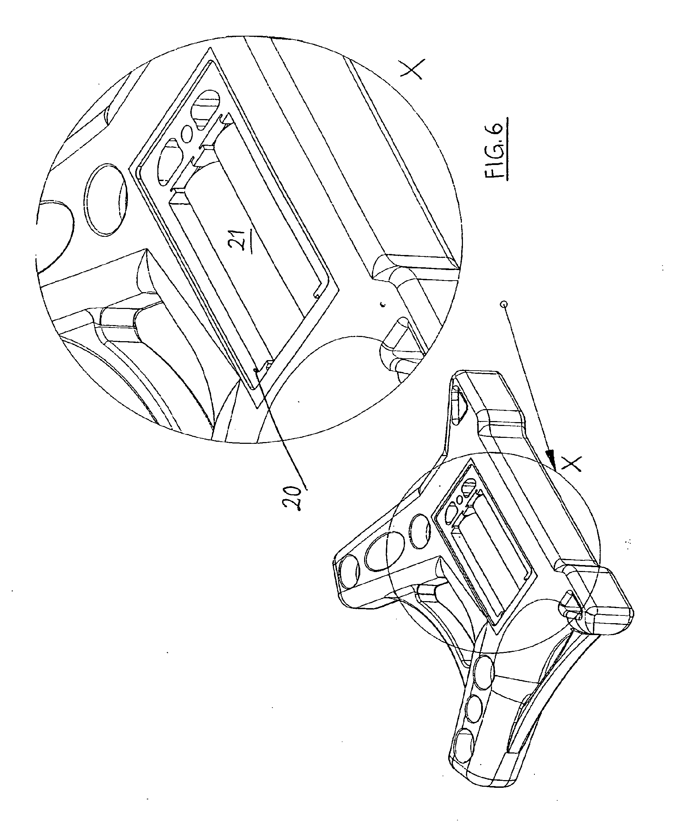

- Figur 6:: eine perspektivische Detailansicht der Stirnseite eines Halteelements,

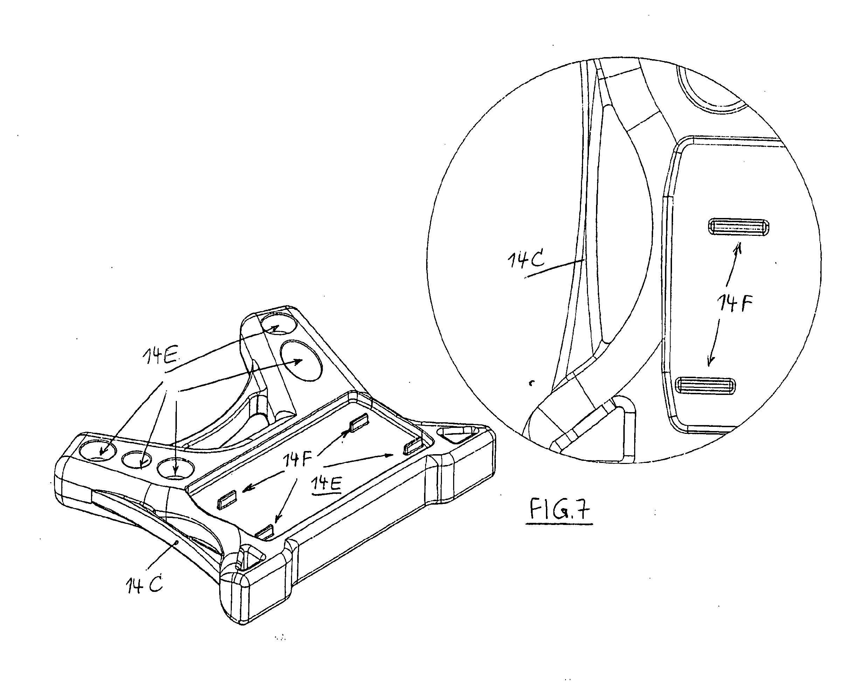

- Figur 7:: eine perspektivische Detailansicht der Innenseite eines Halteelements, und
- Figur 8:: eine Explosionsdarstellung des Bediengeräts mit seinen Bauteilen, und
- Figur 9:: eine Variante eines Halteelements.

### Beschreibung eines Ausführungsbeispiels

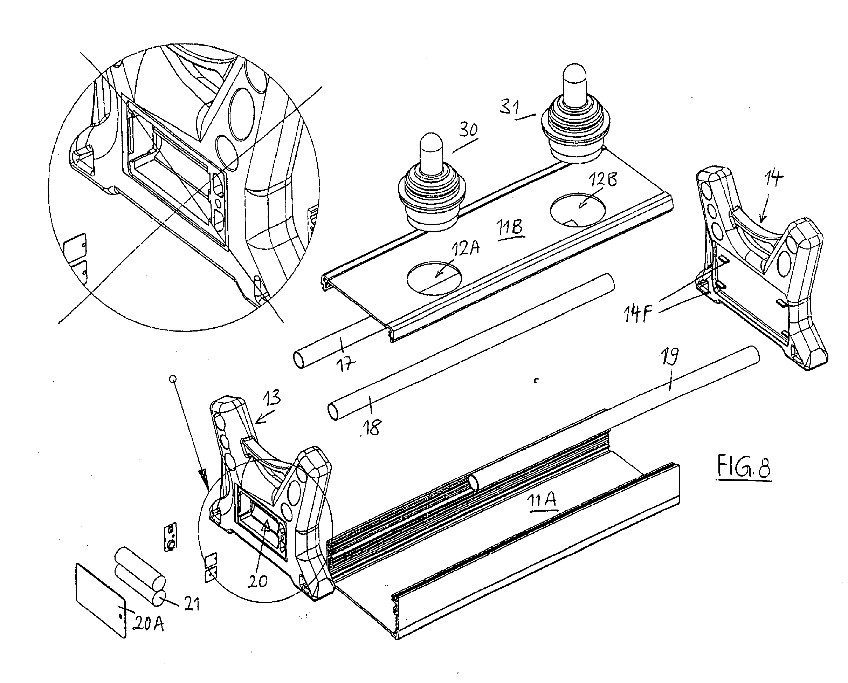

Das Bediengerät besteht aus wenigen Bauteilen, die in der Explosionsdarstellung der Figur 8 dargestellt sind:

Das Gehäuse 10 besteht aus einem quaderförmigen Wandungsteil 11, das aus mindestens einem handelsüblichen Standardprofil besteht. Gemäß Darstellung ist das Wandungsteil 11 aus einem unteren, U-förmigen Bauteil 11A und einem oberen, deckelförmigen Bauteil 11 B aufgebaut, die horizontal miteinander verbindbar sind, beispielsweise durch Einpressen oder Einschieben in geeignete korrespondierende Profilierungen ihrer obigen Randbereiche. Das obere Bauteil 11 B weist kreisförmige Durchbrechungen 12A,12B zum Einsatz von zwei Bedienelementen 30,31 auf, die beim Ausführungsbeispiel als Joysticks dargestellt sind. Innerhalb des Gehäuses sind die üblichen Elektronikbauteile, beispielsweise für einen Fernsteuersender, enthalten, diese sind allgemein bekannt und aus Gründen der Übersichtlichkeit nicht dargestellt.

Die beiden Bauteile 11A, 11B, die das Wandungsteil 11 bilden, sind aus Profilstangen in der gewünschten Länge abgelängt und mit der gewünschten Anzahl von Öffnungen 12A,12B versehen, um die gewünschte Art und Anzahl von Bedienelementen aufnehmen zu können.

Das derart individuell aufgebaute Wandungsteil 11 wird an seinen offenen Stirnseiten mit jeweils einem Halteelement 13,14 verschlossen, das hierzu an seiner dem Wandungsteil 11 zugewandten Innenseite entsprechende Ausnehmungen, Nuten, Nasen oder Profilierungen 14F aufweist, damit eine ortsfixierte Zuordnung und Verbindung von Wandungsteil und Halteelement ermöglicht wird. Die Halteelemente 13,14 sind als Kunststoffformteile einstückig mit einem Auf-Zu-Spritzgusswerk herstellbar und in ihrer Aufsicht etwa X-förmig gestaltet, wobei sie jeweils zwei in Richtung der Bedienelemente 30,31 zeigende Arme 13A, 13B, 14A, 14B und zwei diesen gegenüberliegenden Füße 15A,15B,16A,16B aufweisen.

Die Arme 13A, 13B, 14A, 14B sind so dimensioniert, dass die Ebene, die über ihre oberen Enden verläuft, oberhalb der Bedienungselemente 30,31 verläuft, so dass diese geschützt sind, d.h., auch bei unbeabsichtigten Bewegungen des Bediengerätes werden Stöße oder sonstige äußere Beeinflussungen immer zuverlässig von mindestens einem der Arme eines Halteelementes aufgenommen. Eine wesentliche Funktion der derart konzipierten Halteelemente besteht somit im Schutz der Bedienelemente.

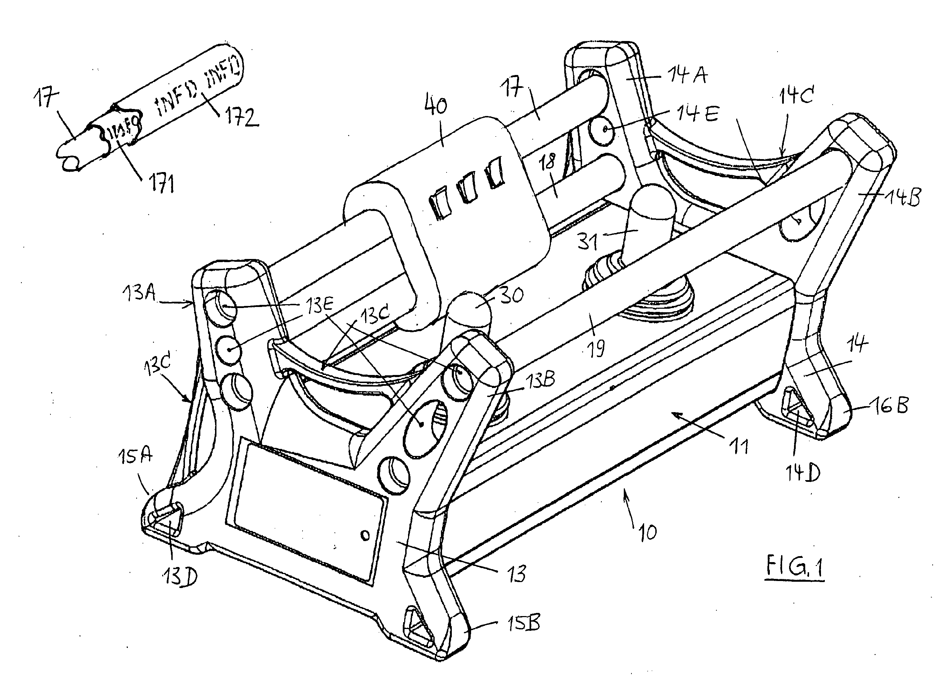

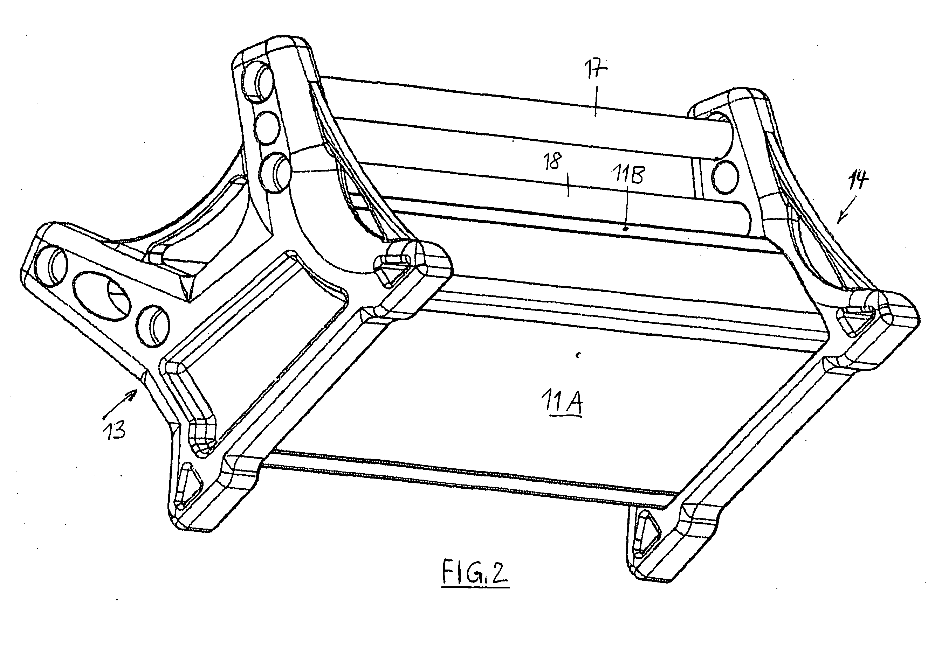

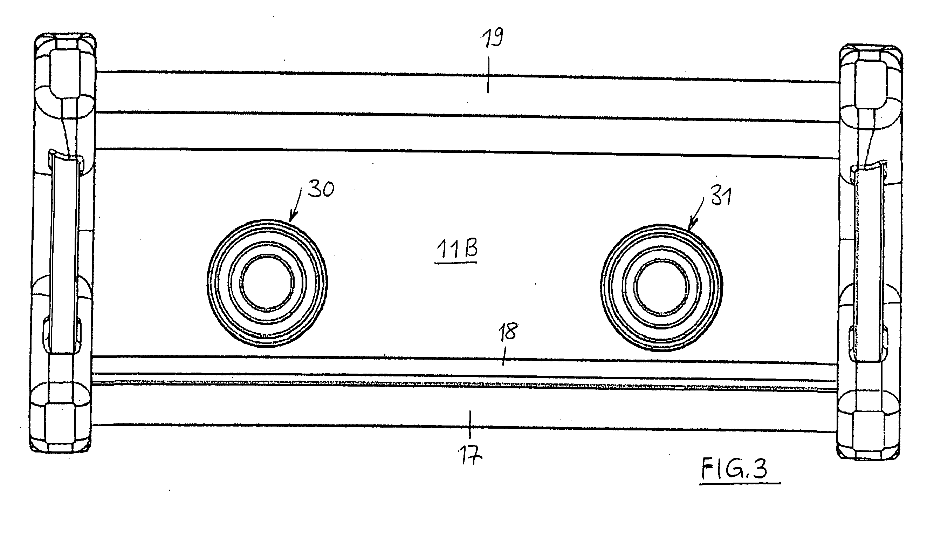

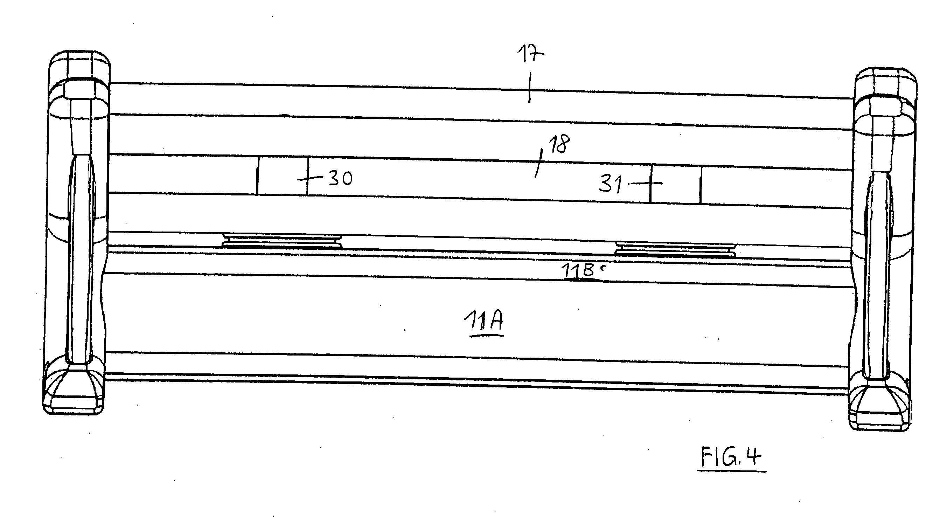

Die Arme 13A,13B,14A,14B weisen mehrere übereinander liegende Ausnehmungen 13E,14E auf, in die beim dargestellten Ausführungsbeispiel drei Stangen 17,18,19 eingesteckt werden können, deren Länge etwas über der Länge des Wandungsteils 11 liegt, so dass eine Struktur gebildet wird, wie sie in den Figuren 1 bis 4 dargestellt ist. Die Stangen 17, 18, 19 können hierbei aus verschiedenen Materialien sein, je nach gewünschtem Erscheinungsbild oder mechanischer Stabilität, sie können in verschiedenen Höhen durch. Einstecken in die verschiedenen Ausnehmungen 13E,14E positioniert werden, so dass sie beispielsweise als weiterer Schutz für die Bedienelemente dienen können, oder aber auch so, dass sie als einzige oder zusätzliche Handauflage .dienen, oder sich am Körper des Benutzers in geeigneter Weise abstützen.

Wandungsteil 11 und/oder die Stangen 17, 18, 19 können Metall- oder Kunststoffprofile sein.

Eine oder mehrere dieser Stangen 17, 18, 19 können auch elektronische Bauteile, wie beispielsweise Antennenarme aufnehmen, die dann über einen Arm eines Halteelementes in das Wandungsteil 11 geführt und mit der dortigen Elektronik verbunden sind.

Eine der Stangen 17, 18, 19 kann aus Metall sein und eine Antenne bilden. Dabei kann die Stange 17, 18, 19 elektrische isoliert sein, wobei die Isolation über einen Kunststoff oder ein weiteres Rohr realisiert sein kann. Insbesondere kann die Isolation durch einen Überzug (Lack) realisiert sein.

Zwischen den Stangen 17 und 18 oder auch zwischen der Stange 19 und der Kante des Wandungsteils 11 kann ein Kunststoffteil 40 gehalten sein, das zusätzliche Bedienelemente oder Displays enthält.

Zumindest eine der Stangen 17, 18, 19 kann ferner mit einem Informationsträger zur Bedienung des mindestens einen Bedienelementes versehen sein, wobei der Informationsträger eine den Umfang der Stange 17 zumindest teilweise überdeckende Folie 171 sein kann. Dabei kann die Folie 171 von einer zumindest teilweise durchsichtigen Schutzfolie 172 umschlossen sein, die vorzugsweise auf die Stange 17 aufgeschrumpft ist.

Eine weitere Ausgestaltung sieht vor, dass in einem der Halteteile 13,14 eine Aufnahme 20 in Form eines Schachtes vorgesehen ist, der derart ausgestaltet und dimensioniert ist, dass Stromversorgungsbauteile 21 wie beispielsweise Batterien oder Akkus eingelegt werden können, die die Elektronikbauteile im Inneren des Wandungsteils 11 versorgen. Die Aufnahme 20 kann bei eingelegten Stromversorgungsbauteilen 21 mit einem Deckel 20A verschlossen werden.

Die Halteteile 13,14 sind außerdem so geformt, dass sie Haltevorrichtungen 13C, 14C enthalten, mit denen das Bediengerät auch ohne Gurt getragen werden kann, durch die von diesen gebildeten Öffnungen können aber auch Gurte geführt werden.

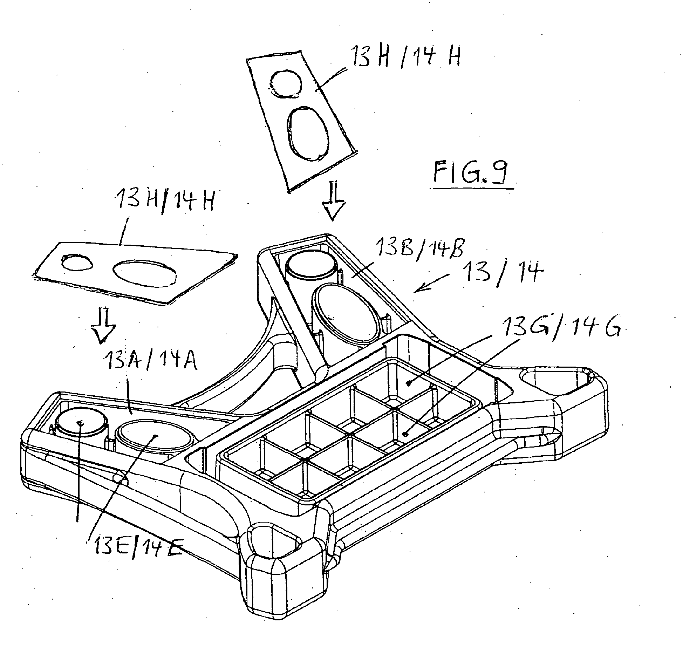

Eine bevorzugte Ausgestaltung eines Halteteils 13, 14 zeigt Figur 9:

Das Bauteil ist als Hohlteil gefertigt, bei dem Stege 13G,14G eine Aufteilung in Kammern bewirken, die zur Aufnahme von Elektronikbauteilen oder auch einer Antenne dienen können. Diese Stege und Wandungen bilden dann auch geeignete Profilierungen zur ortsfesten Fixierung und Positionierung eines Wandungsteils 11. Die Arme 13A,13B14A,14B werden durch Abdeckplatten 13H,14H mit Öffnungen verschlossen, die die Ausnehmungen 13E,14E frei lassen.

Die Füße 15A,15B,16A,16B dienen einerseits zum sicheren Stand des Bediengerätes, schützen andererseits aber bei Stößen oder Fällen das Wandungsteil selbst und die Bedienungselemente vor Beschädigungen.

### Bezugszeichenliste

- Gehäuse: 10
- Wandungsteil: 11
- Bauteile: 11A, 11B
- Öffnungen: 12A, 12B
- Halteelemente: 13, 14
- Arme: 13A, 13B, 14A, 14B
- Haltevorrichtung: 13C, 14C
- Durchbrechungen: 13D, 14D
- Ausnehmungen: 13E, 14E
- Stege: 13G, 14G
- Abdeckplatten: 13H, 14H
- Nasen: 14F
- Füße: 15A, 15B, 16A, 16B
- Stangen: 17, 18, 19
- Aufnahme: 20
- Deckel: 20A
- Stromversorgungsbauteile: 21
- Bedienelemente: 30,31
- Kunststoffteil: 40

## Patentansprüche

1. Bediengerät, insbesondere Fernsteuergerät für Industriegeräte, mit einem Gehäuse zur Aufnahme der Steuerelektronik und mindestens eines Bedienelements,
wobei das Gehäuse (10) aus einem Wandungsteil (11), das aus mindestens einer abgelängten Profilstange besteht, und dessen beide Stirnseiten verschließenden Halteelementen (13,14) gebildet ist
**dadurch gekennzeichnet, dass** die Halteelemente (13,14) zwei in Richtung der Bedienelemente zeigende Arme (13A, 13B, 14A, 14B) aufweisen.

2. Bediengerät nach Anspruch 1, **dadurch gekennzeichnet, dass** das Wandungsteil (11) einen im wesentlichen rechteckigen Querschnitt aufweist.

3. Bediengerät nach Anspruch 1, **dadurch gekennzeichnet, dass** das Wandungsteil (11) aus mindestens einem Metall- oder Kunststoffprofil besteht.

4. Bediengerät nach Anspruch 1, **dadurch gekennzeichnet, dass** das Wandungsteil (11) aus zwei horizontal verbindbaren Bauteilen (11A,11 B) besteht.

5. Bediengerät nach Anspruch 1, **dadurch gekennzeichnet, dass** das Wandungsteil (11) Öffnungen (12A,12B) zur Aufnahme von Bedienelementen (30,31), wie z.B. eines Joysticks, eines Displays oder von LEDs aufweist.

6. Bediengerät nach Anspruch 1, **dadurch gekennzeichnet, dass** die Halteelemente (13,14) Kunststoffformteile sind.

7. Bediengerät nach Anspruch 1, **dadurch gekennzeichnet, dass** die
Arme (13A, 13B, 14A, 14B) Durchbrechungen (13D, 14D) z.B. für Halte-oder Tragegurte aufweisen und die in einer Ebene senkrecht zum Wandungsteil (11) liegen.

8. Bediengerät nach Anspruch 1, **dadurch gekennzeichnet, dass** die Halteelemente (13,14) eine Auflageflächen für die Hände aufweisen.

9. Bediengerät nach Anspruch 7, **dadurch gekennzeichnet, dass** die beiden Arme eines Halteelements (13A,13B;14A,14B) zueinander V-förmig angeordnet sind.

10. Bediengerät nach Anspruch 7, **dadurch gekennzeichnet, dass** die Arme (13A, 13B, 14A, 14B) in einer Ebene senkrecht zum Wandungsteil (11) liegen und eine weitere Ebene zwischen den oberen Enden der vier Arme (13A,13B; 14A, 14B) über den Bedienelementen verläuft.

11. Bediengerät nach Anspruch 1, **dadurch gekennzeichnet, dass** die Halteelemente (13,14) mindestens eine Haltevorrichtung (13C,14C) für die Finger aufweisen, die es erlauben, das Bediengerät auch ohne Gurte zu tragen.

12. Bediengerät nach Anspruch 10, **dadurch gekennzeichnet, dass** die Halteelemente (13,14) gegenüber den Armen (13A,13B,14A,14B) liegende Füße (15A,15B,16A,16B) aufweisen und die gegenüberliegenden Arme (13A,14A; 13B,14B) der beiden Halteelemente (13,14) über Stangen (17,18,19) miteinander verbunden sind, wobei die Stangen (17,18) wahlweise in mehrere Ausnehmungen (13E,14E) innerhalb der Halteelemente (13,14) einsteckbar sind.

13. Bediengerät nach Anspruch 3, **dadurch gekennzeichnet, dass** Wandungsteil (11) und/oder Stangen (17,18,19) Pressstrangprofile aus Metall sind.

14. Bediengerät nach Anspruch 1, **dadurch gekennzeichnet, dass** die Halteelemente (13,14) mindestens eine Aufnahme (20) für Stromversorgungsbauteile (20A) wie Batterie oder Akku sowie Aufnahmen für zusätzliche Bedienelemente wie beispielsweise Schalter aufweist.

15. Bediengerät nach Anspruch 12, **dadurch gekennzeichnet, dass** zwischen Wandungsteil (11) und Stange (17,18,19) ein Kunststoffteil (40) angeordnet ist, das elektronische Komponenten, wie insbesondere eine Antenne, einen Teil einer Antenne und/oder deren Zuleitung, beinhaltet, wobei die Zuleitung zu einem in der Kunststoffstange enthaltenen Antennenstab führt und das Kunststoffteil (40) Bedienelemente wie z.B. Tasten und Schalter und/oder mindestens ein Display und/oder eine LED enthält.

16. Bediengerät nach Anspruch 1, **dadurch gekennzeichnet, dass** die Halteelemente (13,14) aus einem wannenartigen Hohlkörper bestehen, der durch Stege in (13G, 14G) Kammern unterteilt ist und die Oberseite des Hohlkörpers zumindest teilweise durch Abdeckplatten (13H,14H) verschlossen ist und in zumindest einer der Kammern eines Halteelements (13,14) elektronische Bauteile und/oder eine Antenne untergebracht ist/sind.

## Claims

1. Control device, particularly remote control for industrial appliances, comprising a housing for accommodating the control electronics and at least one control element, wherein the housing (10) is formed by a wall part (11) which consists of at least one profiled bar cut to length and holding elements (13, 14) which close the two faces of the wall part, **characterised in that** the holding elements (13, 14) have two arms (13A, 13B, 14A, 14B) pointing in the direction of the control elements.

2. Control device according to claim 1, **characterised in that** the wall part (11) has a substantially rectangular cross-section.

3. Control device according to claim 1, **characterised in that** the wall part (11) consists of at least one metal profile or plastic profile.

4. Control device according to claim 1, **characterised in that** the wall part (11) consists of two horizontally connectable components (11A, 11B).

5. Control device according to claim 1, **characterised in that** the wall part (11) has openings (12A, 12B) for accommodating control elements (30, 31), such as a joystick, a display or LEDs.

6. Control device according to claim 1, **characterised in that** the holding elements (13, 14) are moulded plastic parts.

7. Control device according to claim 1, **characterised in that** the holding elements (13, 14) have two arms (13A, 13B, 14A, 14B) pointing in the direction of the control elements, have breakthroughs (13D, 14D) e.g. for holding straps or carrying straps and which, in one plane, lie perpendicular to the wall part (11).

8. Control device according to claim 1, **characterised in that** the holding elements (13, 14) have a contact surface for the hands.

9. Control device according to claim 7, **characterised in that** the two arms of a holding element (13A, 13B; 14A, 14B) are arranged V-shaped to each other.

10. Control device according to claim 7, **characterised in that** the arms (13A, 13B, 14A, 14B) lie in a plane perpendicular to the wall part (11) and a further plane runs between the upper ends of the four arms (13A, 13B; 14A, 14B) over the control elements.

11. Control device according to claim 1, **characterised in that** the holding elements (13, 14) have at least one holding device (13C, 14C) for the fingers, which permit the control device to be carried even without straps.

12. Control device according to claim 10, **characterised in that** the holding elements (13, 14) have feet (15A, 15B, 16A, 16B) lying opposite the arms (13A, 13B, 14A, 14B) and the opposite arms (13A, 14A; 13B, 14B) of the two holding elements (13, 14) are interconnected by means of bars (17, 18, 19), wherein the bars (17, 18) can be optionally inserted into several recesses (13E, 14E) within the holding elements (13, 14).

13. Control device according to claim 3, **characterised in that** wall part (11) and/or bars (17, 18, 19) are extruded profiles made of metal.

14. Control device according to claim 1, **characterised in that** the holding elements (13, 14) have at least one receptacle (20) for power supply components (20A) such as a battery or accumulator and receptacles for additional control elements such as switches.

15. Control device according to claim 12, **characterised in that**, between wall part (11) and bar (17, 18, 19), a plastic part (40) is arranged which includes electronic components such as particularly an antenna, a part of an antenna and/or the feed thereof, wherein the feed leads to an antenna rod contained in the plastic bar and the plastic part (40) contains control elements such as keys and switches and/or at least one display and/or one LED.

16. Control device according to claim 1, **characterised in that** the holding elements (13, 14) consist of a tray-like hollow body which is divided, by means of webs, into (13G, 14G) chambers and the top of the hollow body is at least partially closed by cover plates (13H, 14H) and electronic components and/or an antenna is/are accommodated in at least one of the chambers of a holding element (13, 14).

## Revendications

1. Appareil de commande, en particulier appareil de télécommande pour appareils industriels, comprenant un boîtier pour loger l'électronique de commande et au moins un élément de commande,
où le boîtier (10) est formé par une partie de paroi (11) constituée d'au moins une barre profilée coupée à longueur et par des éléments de tenue (13, 14) qui ferment les deux côtés latéraux,
**caractérisé en ce que** les éléments de tenue (13, 14) présentent deux bras (13A, 13B, 14A, 14B) s'étendant dans la direction des éléments de commande.

2. Appareil de commande selon la revendication 1, **caractérisé en ce que** la partie de paroi (11) présente une section transversale sensiblement rectangulaire.

3. Appareil de commande selon la revendication 1, **caractérisé en ce que** la partie de paroi (11) est constituée d'au moins un profilé en matière plastique ou métallique.

4. Appareil de commande selon la revendication 1, **caractérisé en ce que** la partie de paroi (11) est constituée de deux constituants (11A, 11B) pouvant être raccordés horizontalement.

5. Appareil de commande selon la revendication 1, **caractérisé en ce que** la partie de paroi (11) présente des ouvertures (12A, 12B) pour loger des éléments de commande (30, 31), comme par exemple un joystick, un dispositif d'affichage ou des diodes électroluminescentes.

6. Appareil de commande selon la revendication 1, **caractérisé en ce que** les éléments de tenue (13, 14) sont des pièces moulées en matière plastique.

7. Appareil de commande selon la revendication 1, **caractérisé en ce que** les bras (13A, 13B, 14A, 14B) présentent des perforations (13D, 14D) par exemple pour des sangles ou des bretelles et qui s'étendent dans un plan perpendiculaire à la partie de la paroi (11).

8. Appareil de commande selon la revendication 1, **caractérisé en ce que** les éléments de tenue (13, 14) présentent une surface d'appui pour les mains.

9. Appareil de commande selon la revendication 7, **caractérisé en ce que** les deux bras (13A, 13B, 14A, 14B) d'un élément de tenue sont disposés en forme de V l'un par rapport à l'autre.

10. Appareil de commande selon la revendication 7, **caractérisé en ce que** les bras (13A, 13B, 14A, 14B) se situent dans un plan perpendiculaire à la partie de la paroi (11) et un autre plan s'étend entre les extrémités supérieures des quatre bras (13A, 13B, 14A, 14B) au-dessus des éléments de commande.

11. Appareil de commande selon la revendication 1, **caractérisé en ce que** les éléments de tenue (13, 14) présentent au moins un dispositif de tenue (13C, 14C) pour les doigts, qui permet de porter l'appareil de commande également sans bretelle.

12. Appareil de commande selon la revendication 10, **caractérisé en ce que** les éléments de tenue (13, 14) présentent des pieds (15A, 15B, 16A, 16B) s'étendant en face des bras (13A, 13B, 14A, 14B) et les bras (13A, 13B, 14A, 14B) opposés des deux éléments de tenue (13, 14) sont reliés entre eux par des barres (17, 18, 19), les barres (17, 18) pouvant être sélectivement insérées dans plusieurs évidements (13E, 14E) à l'intérieur des éléments de tenue (13, 14).

13. Appareil de commande selon la revendication 3, **caractérisé en ce que** la partie de paroi (11) et/ou les barres (17, 18, 19) sont des profilés extrudés en métal.

14. Appareil de commande selon la revendication 1, **caractérisé en ce que** les éléments de tenue (13, 14) présentent au moins un logement (20) pour des composants d'alimentation en courant (20A) tels qu'une batterie ou un accumulateur ainsi que des logements pour des éléments de commande supplémentaires comme par exemple des commutateurs.

15. Appareil de commande selon la revendication 12, **caractérisé en ce qu'**une pièce en matière plastique (40) est disposée entre partie de paroi (11) et tige (17, 18, 19), et contient des composants électroniques, tels qu'en particulier une antenne, une partie d'une antenne et/ou son câble d'alimentation, où le câble d'alimentation mène à une antenne en bâton contenue dans la tige en matière plastique et la pièce en matière plastique (40) contient des éléments de commande comme par exemple des touches et des commutateurs et/ou au moins un dispositif d'affichage et/ou une diode électroluminescente.

16. Appareil de commande selon la revendication 1, **caractérisé en ce que** les éléments de tenue (13, 14) sont constitués par un corps creux du genre cuve, qui se subdivise en cavités (13G, 14G) par des ailettes et le côté supérieur du corps creux est fermé au moins partiellement par des plaques de recouvrement (13H, 14H), et des composants électroniques et/ou une antenne est/sont logé(s) dans au moins une des cavités d'un élément de tenue (13, 14).
